# DEMANDE DE BREVET EUROPEEN

(11) **EP 4 373 239 A1**
(43) Date de publication de la demande: **22.05.2024**
(21) Numéro de dépôt: 23209580.2
(22) Date de dépôt: 14.11.2023
(51) Int. Cl.: H10K 59/12, H10K 59/121, H10K 59/123, H10K 59/131, H10K 59/80

(54) **PROCEDE DE FABRICATION D'UN DISPOSITIF ELECTROLUMINESCENT ORGANIQUE**

(30) Priorité: 17.11.2022 FR 2211969
(71) Demandeur: Commissariat à l'énergie atomique et aux énergies alternatives, 75015 Paris (FR)
(72) Inventeur: TOURNAIRE, Myriam, 38054 Grenoble Cedex 09 (FR); MAINDRON, Tony, 38054 Grenoble Cedex 09 (FR)
(74) Mandataire: INNOV-GROUP

(57) **Abrégé**

Procédé de fabrication d'un dispositif électroluminescent organique sur un empilement comportant successivement :
- un substrat (1), intégrant des transistors (10) de type n en couches minces comprenant chacun un drain (D), une source (S) et une grille (G) ;
- une structure d'interconnexions (2), électriquement connectée aux transistors (10) de type n, et comprenant :
une anode commune (20), électriquement connectée aux sources (S) des transistors (10) de type n ;
des trous d'interconnexions (21), chacun étant électriquement connecté à un drain (D) d'un transistor (10) de type n ;
le dispositif électroluminescent organique étant formé selon une architecture directe avec une singularisation d'une cathode (6) à l'échelle du pixel pilotable à l'aide d'un plot (4) de contact électrique dédié à un pixel.

## Description

### Domaine technique

L'invention se rapporte au domaine technique de la fabrication d'un dispositif électroluminescent organique, en particulier d'un micro-écran à diodes électroluminescentes organiques.

L'invention trouve notamment son application dans la fabrication de lunettes et casques à réalité virtuelle ou augmentée, de viseurs d'appareils-photos, d'afficheurs tête-haute, de pico-projecteurs etc.

### État de l'art

Un procédé de fabrication d'un dispositif électroluminescent organique connu de l'état de la technique, notamment du document H.-H. Hsieh et al., « A 2.4 in. AMOLED with IGZO TFTs and inverted OLED Devices », SID, vol.40, Issue 1, 2010, comporte les étapes :
a₀₁) utiliser un empilement comportant successivement :
   - un substrat, intégrant des transistors de type n en couches minces comprenant chacun un drain, une source et une grille ;
   - une structure d'interconnexions, électriquement connectée aux transistors de type n, et comprenant :
      des premiers trous d'interconnexions, chacun étant électriquement connecté à une source d'un transistor de type n ;
      des deuxièmes trous d'interconnexions, chacun étant électriquement connecté à un drain d'un transistor de type n ;
b₀₁) former :
   - un ensemble de couches anodiques sur la structure d'interconnexions, espacées entre elles de manière à former un réseau de lignes et de colonnes, chaque couche anodique étant électriquement connectée à un premier trou d'interconnexion,
   - un plot de contact électrique sur la structure d'interconnexions, adjacent à l'ensemble de couches anodiques, et électriquement connecté aux deuxièmes trous d'interconnexion ;
c₀₁) former un ensemble d'empilements de couches semi-conductrices organiques, chaque empilement de couches semi-conductrices organiques s'étendant sur une couche anodique et autour de ladite couche anodique ;
d₀₁) former une cathode commune s'étendant sur la structure d'interconnexions, sur l'ensemble d'empilements de couches semi-conductrices organiques et sur le plot de contact électrique.

Il apparaît intéressant d'utiliser des transistors de type n en couches minces (TFT pour « *Thin Film Transistors* » en langue anglaise), le canal pouvant être réalisé dans un oxyde transparent conducteur (TCO pour « *Transparent Conductive Oxide* » en langue anglaise), dans un oxyde semi-conducteur transparent (TSO pour « *Transparent Semiconducting Oxide* » en langue anglaise) tel que l'oxyde d'Indium-Gallium-Zinc In-Ga-Zn (IGZO). En particulier, l'IGZO a montré une meilleure stabilité en courant pour piloter le dispositif électroluminescent organique tel qu'un micro-écran à diodes électroluminescentes organiques. Les TFT sont classiquement agencés de manière à former un schéma d'alimentation et d'adressage des pixels de type 2T-1C, c'est-à-dire deux transistors de type TFT et une capacité pilotent un pixel.

Toutefois, un tel procédé de l'état de la technique n'est pas entièrement satisfaisant dans la mesure où il a été constaté une dérive de la tension V_{GS} (tension entre la grille et la source) qui conduit à un marquage important et à une image rémanente.

Un procédé de fabrication d'un dispositif électroluminescent organique connu de l'état de la technique, notamment du document H.-H. Hsieh et al., « A 2.4 in. AMOLED with IGZO TFTs and inverted OLED Devices », SID, vol.40, Issue 1, 2010, comporte les étapes :
a₀₂) utiliser un empilement comportant successivement :
   - un substrat, intégrant des transistors de type n en couches minces comprenant chacun un drain, une source et une grille ;
   - une structure d'interconnexions, électriquement connectée aux transistors de type n, et comprenant :
      des premiers trous d'interconnexions, chacun étant électriquement connecté à une source d'un transistor de type n ;
      des deuxièmes trous d'interconnexions, chacun étant électriquement connecté à un drain d'un transistor de type n ;
b₀₂) former :
   - un ensemble de couches cathodiques sur la structure d'interconnexions, espacées entre elles de manière à former un réseau de lignes et de colonnes, chaque couche cathodique étant électriquement connectée à un premier trou d'interconnexion,
   - un plot de contact électrique sur la structure d'interconnexions, adjacent à l'ensemble de couches cathodiques, et électriquement connecté aux deuxièmes trous d'interconnexion ;
c₀₂) former un ensemble d'empilements de couches semi-conductrices organiques, chaque empilement de couches semi-conductrices organiques s'étendant sur une couche cathodique et autour de ladite couche cathodique ;
d₀₂) former une anode commune s'étendant sur la structure d'interconnexions, sur l'ensemble d'empilements de couches semi-conductrices organiques et sur le plot de contact électrique.

Un tel procédé de l'état de la technique forme le dispositif électroluminescent (i.e. les empilements de couches semi-conductrices, les couches cathodiques et l'anode commune) en inverse, c'est-à-dire que l'anode se retrouve en position supérieure de l'empilement par rapport à la cathode. Une telle architecture inversée permet de réduire drastiquement le marquage.

Toutefois, un tel procédé de l'état de la technique n'est pas entièrement satisfaisant avec une résistance série importante due à un problème d'injection de porteurs entre la couche cathodique et l'empilement de couches semi-conductrices organiques (plus précisément avec la couche d'injection d'électrons), cf. J. Wang et al., « Efficient inverted organic light-emitting devices using a charge-generation unit as electron-injection layers », Organic Electronics, vol. 96, 106202, 2021 et S. Madasamy et al, « Au overview about the use of electrical doping of charge carrier transport layers in OLEDs and further organic electronic applications», Proc. SPIE 6999, Organic Optoelectronics and Photonics III, 69991E, 2008.

### Exposé de l'invention

L'invention vise à remédier en tout ou partie aux inconvénients précités. A cet effet, l'invention a pour objet un procédé de fabrication d'un dispositif électroluminescent organique, comportant les étapes :
a) utiliser un empilement comportant successivement :
   - un substrat, intégrant des transistors de type n en couches minces comprenant chacun un drain, une source et une grille ;
   - une structure d'interconnexions, électriquement connectée aux transistors de type n, et comprenant :
      une anode commune, électriquement connectée aux sources des transistors de type n ;
      des trous d'interconnexions, chacun étant électriquement connecté à un drain d'un transistor de type n ;
b) former un ensemble de couches anodiques et un ensemble de plots de contact électrique sur la structure d'interconnexions, les couches anodiques étant espacées entre elles de manière à former un réseau de lignes et de colonnes, chaque couche anodique étant électriquement connectée à l'anode commune ; chaque plot de contact électrique étant adjacent à une couche anodique et étant électriquement connecté à un trou d'interconnexion ;
c) former un ensemble d'empilements de couches semi-conductrices organiques, chaque empilement de couches semi-conductrices organiques s'étendant sur une couche anodique et autour de ladite couche anodique, à distance du plot de contact électrique adjacent à ladite couche anodique ;
d) former une couche cathodique s'étendant sur la structure d'interconnexions, sur l'ensemble d'empilements de couches semi-conductrices organiques et sur l'ensemble de plots de contact électrique ;
e) former successivement une couche de recouvrement optique et une couche d'encapsulation sur la couche cathodique ;
f) graver localement la couche d'encapsulation, la couche de recouvrement optique et la couche cathodique de manière à isoler électriquement les couches anodiques entre elles et former une matrice de pixels ; chaque pixel comprenant une couche anodique et un plot de contact électrique, adjacent à ladite couche anodique.

Autrement dit, l'étape b) consiste à former un ensemble de couches anodiques et un ensemble de plots de contact électrique sur une surface de la structure d'interconnexions, les couches anodiques étant espacées entre elles de manière à former un réseau de lignes et de colonnes, chaque couche anodique étant électriquement connectée à l'anode commune ; chaque plot de contact électrique étant adjacent à une couche anodique et étant électriquement connecté à un trou d'interconnexion.

Autrement dit, l'étape d) consiste à former une couche cathodique s'étendant sur la surface de la structure d'interconnexions, sur l'ensemble d'empilements de couches semi-conductrices organiques et sur l'ensemble de plots de contact électrique.

Autrement dit, l'étape f) consiste à graver localement la couche d'encapsulation, la couche de recouvrement optique et la couche cathodique jusqu'à atteindre la surface de la structure d'interconnexions, de manière à isoler électriquement les couches anodiques entre elles de la couche cathodique et former une matrice de pixels ; chaque pixel comprenant une couche anodique et un plot de contact électrique, adjacent à ladite couche anodique.

Ainsi, un tel procédé selon l'invention permet de conserver une architecture directe (c'est-à-dire non inversée) en anode commune, la cathode se retrouvant en position supérieure de l'empilement par rapport à l'anode. Le procédé selon l'invention permet, grâce à l'étape f), de singulariser la cathode à l'échelle du pixel alors qu'il est très difficile, voire impossible de déposer localement une cathode sur un empilement de couches semi-organiques conductrices correspondant à un pixel, en particulier lorsque le pas (« *pitch »* en langue anglaise) est inférieur ou égal à 10 µm. Chaque pixel peut être piloté par le plot de contact électrique correspondant. Le marquage est réduit par rapport à l'état de la technique grâce à cette singularisation de la cathode à l'échelle du pixel qui permet d'atténuer les phénomènes de diaphonie (« *crosstalk* » en langue anglaise) entre les pixels adjacents.

Le procédé selon l'invention peut comporter une ou plusieurs des caractéristiques suivantes.

Selon une caractéristique de l'invention, l'étape f) est exécutée par une gravure par faisceau d'ions.

Selon une caractéristique de l'invention, l'étape f) est précédée d'une étape consistant à former un masque de gravure photosensible sur la couche d'encapsulation formée lors de l'étape e), le masque de gravure photosensible étant adapté pour délimiter la matrice de pixels.

Selon une caractéristique de l'invention, l'étape b) est exécutée de sorte que le réseau de lignes et de colonnes présente un pas inférieur ou égal à 10 µm.

Selon une caractéristique de l'invention, l'étape f) forme des zones gravées ; et l'étape f) est suivie d'une étape g) consistant à remplir les zones gravées d'un matériau d'encapsulation, de préférence l'alumine Al₂O₃.

Ainsi, un avantage procuré est de protéger les pixels de l'air et de l'humidité.

Selon une caractéristique de l'invention, l'étape e) est exécutée de sorte que la couche de recouvrement optique est réalisée en monoxyde de silicium SiO.

Selon une caractéristique de l'invention, l'étape e) est exécutée de sorte que la couche d'encapsulation est réalisée en alumine Al₂O₃.

Selon une caractéristique de l'invention, l'étape d) est exécutée de sorte que la couche cathodique est réalisée en argent Ag.

Selon une caractéristique de l'invention, les étapes d) et e) sont exécutées de sorte que la couche cathodique, la couche de recouvrement optique et la couche d'encapsulation présentent une épaisseur totale inférieure ou égale à 75 nm.

Ainsi, un avantage procuré est de faciliter la gravure lors de l'étape f).

Selon une caractéristique de l'invention :
- l'étape c) est exécutée avec un masque d'ombre ;
- l'étape d) est exécutée sans masque d'ombre.

Ainsi, un avantage procuré est notamment de réduire les problèmes de maintenance liés à des contaminations particulaires provoquées par la manipulation des masques d'ombre.

Selon une caractéristique de l'invention, l'étape c) est suivie d'une étape consistant à retirer le masque d'ombre dans une atmosphère inerte.

### Définitions

- Par « substrat », on entend un support physique autoporté, réalisé dans un matériau de base à partir duquel peut être formé un dispositif électroluminescent. Un substrat peut être une « tranche » (également dénommée « plaquette », « *wafer* » en langue anglaise) qui se présente généralement sous la forme d'un disque issu d'une découpe dans un lingot d'un matériau cristallin.
- Par « empilement », on entend une succession de couches suivant une direction verticale (i.e. suivant la normale à la surface du substrat où est formée la structure d'interconnexions).
- Par « structure d'interconnexions », on entend un empilement de niveaux d'interconnexions comprenant des pistes métalliques noyées dans un matériau diélectrique. Une structure d'interconnexions est classiquement formée sur le substrat par une unité de fabrication initiale BEOL (« *Back-End-Of-Line* » en langue anglaise).
- Par « anode commune », on entend une anode destinée à être commune à tous les pixels.
- Par « trou d'interconnexions » (« *via* » en langue anglaise), on entend un trou métallisé permettant d'établir une liaison électrique, notamment entre des niveaux d'interconnexion.
- Par « couche cathodique », on entend une couche adaptée pour former une cathode, c'est-à-dire une électrode qui donne les électrons lorsque le dispositif électroluminescent est polarisé.
- Par « couche anodique », on entend une couche adaptée pour former une anode, c'est-à-dire une électrode qui donne les trous (ou reçoit les électrons) lorsque le dispositif électroluminescent est polarisé.
- Par « couche de recouvrement optique » (« *capping layer* » en langue anglaise), on entend une couche dont l'indice optique et l'épaisseur sont adaptés pour optimiser l'extraction de lumière du dispositif électroluminescent.
- Par « couche d'encapsulation », on entend une couche adaptée pour protéger le dispositif électroluminescent de l'air et de l'humidité.
- Le terme « masque d'ombre » (« *shadow mask* » en langue anglaise) est également connu sous le terme de pochoir.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe, illustrant l'étape a) d'un procédé selon l'invention.
Figure 2 est une vue schématique en coupe, illustrant l'étape b) d'un procédé selon l'invention.
Figure 3 est une vue schématique en coupe, illustrant l'étape c) d'un procédé selon l'invention. Pour des raisons de simplicité, chaque empilement de couches semi-conductrices organiques est représenté par une seule couche.
Figure 4 est une vue schématique en coupe, illustrant l'étape d) d'un procédé selon l'invention.
Figure 5 est une vue schématique en coupe, illustrant l'étape e) d'un procédé selon l'invention. Pour des raisons de simplicité, la couche de recouvrement optique et la couche d'encapsulation sont représentées par une seule couche.
Figure 6 est une vue schématique en coupe, illustrant une étape de formation d'un masque de gravure photosensible précédant l'étape f).
Figure 7 est une vue schématique en coupe, illustrant l'étape f) d'un procédé selon l'invention avec le masque de gravure illustré à la figure 6.
Figure 8 est une vue schématique en coupe, illustrant l'étape g) d'un procédé selon l'invention suivant l'étape f) illustrée à la figure 7.

Il est à noter que les dessins décrits ci-avant sont schématiques, et ne sont pas nécessairement à l'échelle par souci de lisibilité et pour en simplifier leur compréhension. Les coupes sont effectuées selon la normale à la surface du substrat où est formée la structure d'interconnexions.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'un dispositif électroluminescent organique, comportant les étapes :
a) utiliser un empilement comportant successivement :
   - un substrat 1, intégrant des transistors 10 de type n en couches minces comprenant chacun un drain D, une source S et une grille G ;
   - une structure d'interconnexions 2, électriquement connectée aux transistors 10 de type n, et comprenant :
      une anode commune 20, électriquement connectée aux sources S des transistors 10 de type n ;
      des trous d'interconnexions 21, chacun étant électriquement connecté à un drain D d'un transistor 10 de type n ;
b) former un ensemble de couches anodiques 3 et un ensemble de plots 4 de contact électrique sur la structure d'interconnexions 2, les couches anodiques 3 étant espacées entre elles de manière à former un réseau de lignes et de colonnes, chaque couche anodique 3 étant électriquement connectée à l'anode commune 20 ; chaque plot 4 de contact électrique étant adjacent à une couche anodique 3 et étant électriquement connecté à un trou d'interconnexion 21 ;
c) former un ensemble d'empilements 5 de couches semi-conductrices organiques, chaque empilement 5 de couches semi-conductrices organiques s'étendant sur une couche anodique 3 et autour de ladite couche anodique 3, à distance du plot 4 de contact électrique adjacent à ladite couche anodique 3 ;
d) former une couche cathodique 6 s'étendant sur la structure d'interconnexions 2, sur l'ensemble d'empilements 5 de couches semi-conductrices organiques et sur l'ensemble de plots 4 de contact électrique ;
e) former successivement une couche de recouvrement optique 7 et une couche d'encapsulation 8 sur la couche cathodique 6 ;
f) graver localement la couche d'encapsulation 8, la couche de recouvrement optique 7 et la couche cathodique 6 de manière à isoler électriquement les couches anodiques 3 entre elles et former une matrice de pixels ; chaque pixel comprenant une couche anodique 3 et un plot 4 de contact électrique, adjacent à ladite couche anodique 3.

### Etape a)

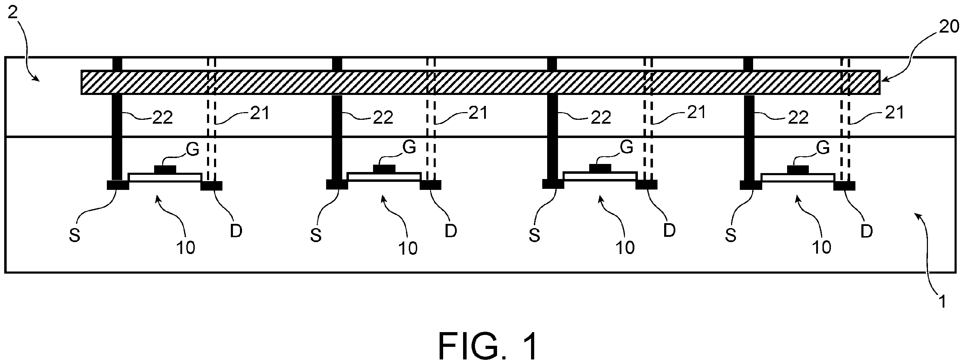

L'étape a) est illustrée à la figure 1.

L'étape a) consiste à utiliser un empilement comportant successivement :
- un substrat 1, intégrant des transistors 10 de type n en couches minces comprenant chacun un drain D, une source S et une grille G ;
- une structure d'interconnexions 2, électriquement connectée aux transistors 10 de type n, et comprenant :
   une anode commune 20, électriquement connectée aux sources S des transistors 10 de type n ;
   des trous d'interconnexions 21, chacun étant électriquement connecté à un drain D d'un transistor 10 de type n.

A titre d'exemple non limitatif, le substrat 1 peut être réalisé en silicium.

Les transistors de type n en couches minces (TFT pour « *Thin Film Transistors* » en langue anglaise) possèdent un canal pouvant être réalisé dans :
- un oxyde transparent conducteur (TCO pour « *Transparent Conductive Oxide* » en langue anglaise),
- un oxyde semi-conducteur transparent (TSO pour « *Transparent S emiconducting Oxide* » en langue anglaise) tel que l'oxyde d'Indium-Gallium-Zinc In-Ga-Zn (IGZO).

En particulier, l'IGZO a montré une meilleure stabilité en courant pour piloter le dispositif électroluminescent organique tel qu'un micro-écran à diodes électroluminescentes organiques. Par « micro-écran », on entend un écran dont chaque pixel présente une surface inférieure ou égale à 30 µm par 30 µm.

Les transistors 10 de type n en couches minces sont avantageusement agencés de manière à former un schéma d'alimentation et d'adressage des pixels de type 2T-1C, c'est-à-dire deux transistors de type TFT et une capacité pilotent un pixel.

L'anode commune 20 est électriquement connectée aux sources S des transistors 10 de type n, préférentiellement par des trous d'interconnexions additionnels 22. L'anode commune 20 est avantageusement enterrée au sein de la structure d'interconnexions 2. L'anode commune 20 peut être réalisée dans un matériau métallique. A titre d'exemple non limitatif, le matériau métallique peut comporter une première couche d'un alliage aluminium-cuivre (Al-Cu) et une seconde couche de nitrure de titane TiN.

Lorsque le substrat 1 est réalisé en silicium, les trous d'interconnexions 21 et les trous d'interconnexions additionnels 22 peuvent être de type via traversant TSV (« *Through-Silicon Via* » en langue anglaise).

### Etape b)

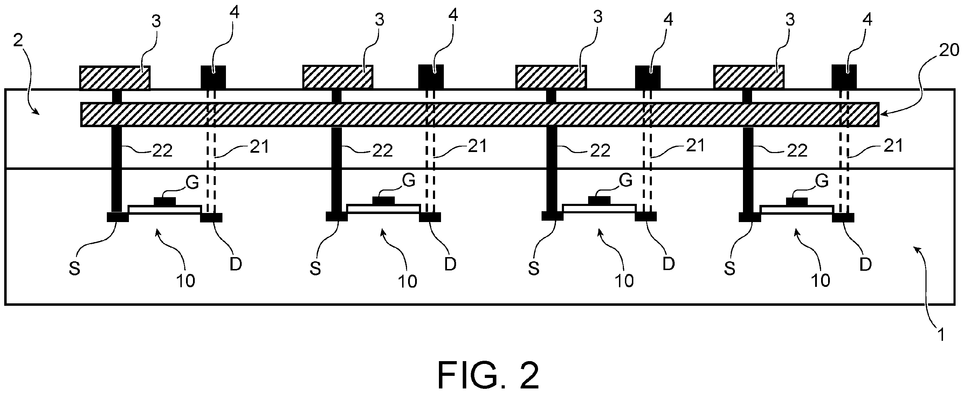

L'étape b) est illustrée à la figure 2.

L'étape b) consiste à former un ensemble de couches anodiques 3 et un ensemble de plots 4 de contact électrique sur la structure d'interconnexions 2, les couches anodiques 3 étant espacées entre elles de manière à former un réseau de lignes et de colonnes. Autrement dit, l'étape b) consiste à former un ensemble de couches anodiques 3 et un ensemble de plots 4 de contact électrique sur une surface de la structure d'interconnexions 2, les couches anodiques 3 étant espacées entre elles de manière à former un réseau de lignes et de colonnes.

L'ensemble de couches anodiques 3 et l'ensemble de plots 4 de contact électrique peuvent être déposés simultanément sur la structure d'interconnexions 2 (dernier niveau de métallisation), par exemple par un dépôt physique en phase vapeur. Puis l'ensemble de couches anodiques 3 et l'ensemble de plots 4 de contact électrique peuvent être formés (i.e. délimités) par photolithographie, par exemple à l'aide d'une résine photosensible qui sera ensuite retirée (« *stripping* » en langue anglaise). L'ensemble de couches anodiques 3 et l'ensemble de plots 4 de contact électrique peuvent être réalisés dans un matériau métallique. A titre d'exemple non limitatif, le matériau métallique peut comporter une première couche d'un alliage aluminium-cuivre (Al-Cu) et une seconde couche de nitrure de titane TiN. Chaque couche anodique 3 est électriquement connectée à l'anode commune 20, préférentiellement par les trous d'interconnexions additionnels 22. Chaque plot 4 de contact électrique est adjacent à une couche anodique 3 et est électriquement connecté à un trou d'interconnexion 21. Chaque plot 4 de contact électrique est donc connecté à un drain D d'un transistor 10 de type n.

L'étape b) est avantageusement exécutée de sorte que le réseau de lignes et de colonnes présente un pas (i.e. période spatiale) inférieur ou égal à 10 µm.

### Etape c)

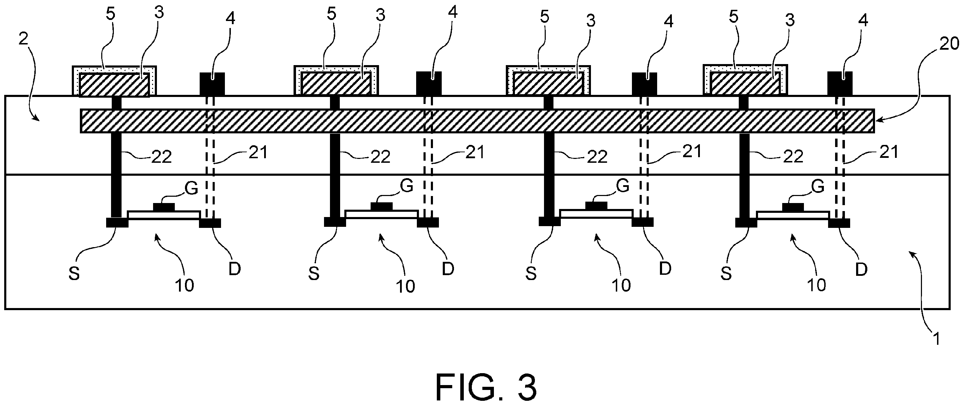

L'étape c) est illustrée à la figure 3.

L'étape c) consiste à former un ensemble d'empilements 5 de couches semi-conductrices organiques, chaque empilement 5 de couches semi-conductrices organiques s'étendant sur une couche anodique 3 et autour de ladite couche anodique 3, à distance du plot 4 de contact électrique adjacent à ladite couche anodique 3.

A titre d'exemple non limitatif, chaque empilement 5 de couches semi-conductrices organiques peut comporter successivement :
- une couche d'injection de trous HIL (« *Hole Injection Layer* » en langue anglaise) formée sur la couche anodique 3 ;
- une couche de transport de trous HTL (« *Hole Transport Layer* » en langue anglaise) ;
- une couche émissive EML (« *Emissive Layer* » en langue anglaise ») ;
- une couche de transport d'électrons ETL (« *Electron Transport Layer* » en langue anglaise) ;
- une couche d'injection d'électrons EIL (« *Electron Injection Layer* » en langue anglaise).

A titre de variante, chaque empilement 5 de couches semi-conductrices organiques peut comporter successivement :
- une couche d'injection de trous HIL formée sur la couche anodique 3 ;
- une couche de transport de trous HTL ;
- une couche émissive EML ;
- une couche de blocage de trous HBL (« *Hole Blocking Layer* » en langue anglaise) ;
- une couche de transport d'électrons ETL.

L'étape c) peut être exécutée avec un masque d'ombre. L'étape c) est avantageusement suivie d'une étape consistant à retirer le masque d'ombre dans une atmosphère inerte, par exemple à base de diazote N₂ ou d'argon Ar.

Les empilements 5 de couches semi-conductrices organiques peuvent être formés par une technique de dépôt connue de l'homme du métier, par exemple un dépôt physique par phase vapeur PVD (« *Phase Vapor Deposition* » en langue anglaise). A titre d'exemple non limitatif, chaque empilement 5 de couches semi-conductrices organiques peut présenter une épaisseur de l'ordre de 100 nm.

### Etape d)

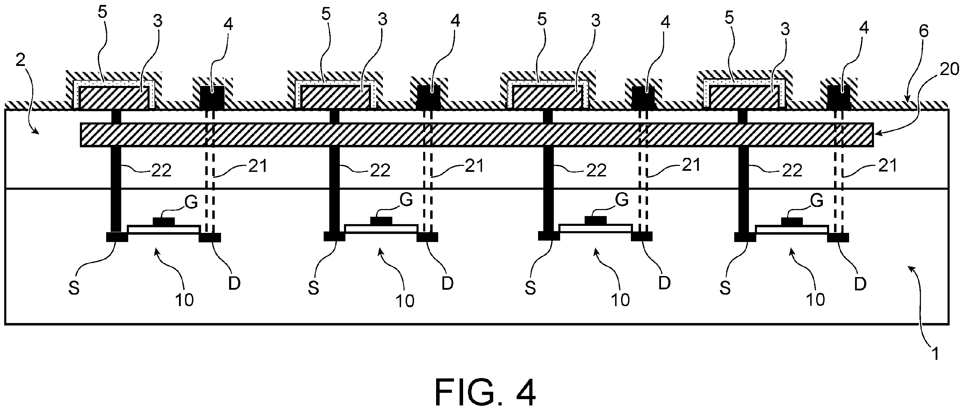

L'étape d) est illustrée à la figure 4.

L'étape d) consiste à former une couche cathodique 6 s'étendant sur la structure d'interconnexions 2, sur l'ensemble d'empilements 5 de couches semi-conductrices organiques et sur l'ensemble de plots 4 de contact électrique. Autrement dit, l'étape d) consiste à former une couche cathodique 6 s'étendant sur la surface de la structure d'interconnexions 2, sur l'ensemble d'empilements 5 de couches semi-conductrices organiques et sur l'ensemble de plots 4 de contact électrique.

L'étape d) est avantageusement exécutée de sorte que la couche cathodique 6 est réalisée dans un matériau métallique, préférentiellement en argent Ag. A titre d'exemple non limitatif, la couche cathodique 6 peut présenter une épaisseur de l'ordre de 15 nm.

L'étape d) est avantageusement exécutée sans masque d'ombre. En d'autres termes, la couche cathodique 6 est formée par un dépôt de type pleine plaque.

### Etape e)

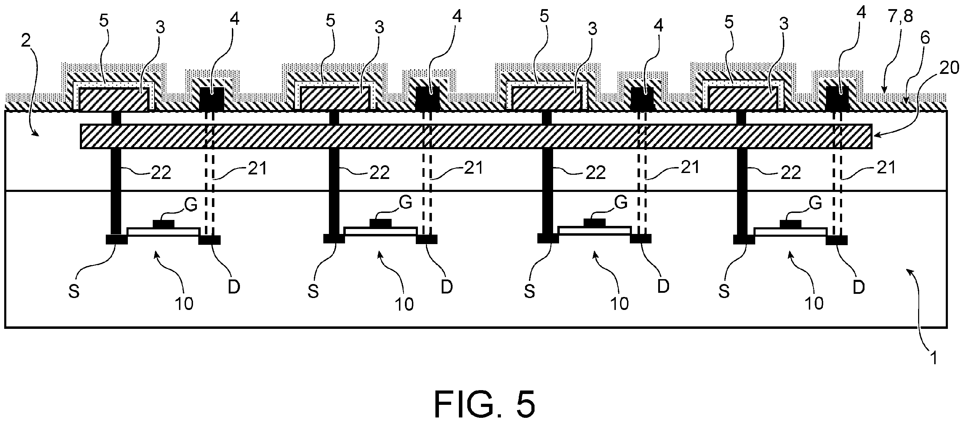

L'étape e) est illustrée à la figure 5.

L'étape e) consiste à former successivement une couche de recouvrement optique 7 et une couche d'encapsulation 8 sur la couche cathodique 6.

L'étape e) est avantageusement exécutée de sorte que la couche de recouvrement optique 7 est réalisée en monoxyde de silicium SiO. A titre d'exemple non limitatif, la couche de recouvrement optique 7 peut être formée sur la couche cathodique 6 par un dépôt physique par phase vapeur PVD. La couche de recouvrement optique 7 est électriquement isolante. A titre d'exemple non limitatif, la couche de recouvrement optique 7 peut présenter une épaisseur de l'ordre de 25 nm.

L'étape e) est avantageusement exécutée de sorte que la couche d'encapsulation 8 est réalisée en alumine Al₂O₃. La couche d'encapsulation 8 en alumine Al₂O₃ est préférentiellement formée sur la couche de recouvrement optique 7 par un dépôt de couches atomiques ALD (« *Atomic Layer Deposition* » en langue anglaise). La couche d'encapsulation 8 est électriquement isolante. A titre d'exemple non limitatif, la couche d'encapsulation 8 peut présenter une épaisseur de l'ordre de 25 nm.

Les étapes d) et e) sont avantageusement exécutées de sorte que la couche cathodique 6, la couche de recouvrement optique 7 et la couche d'encapsulation 8 présentent une épaisseur totale inférieure ou égale à 75 nm.

### Etape f)

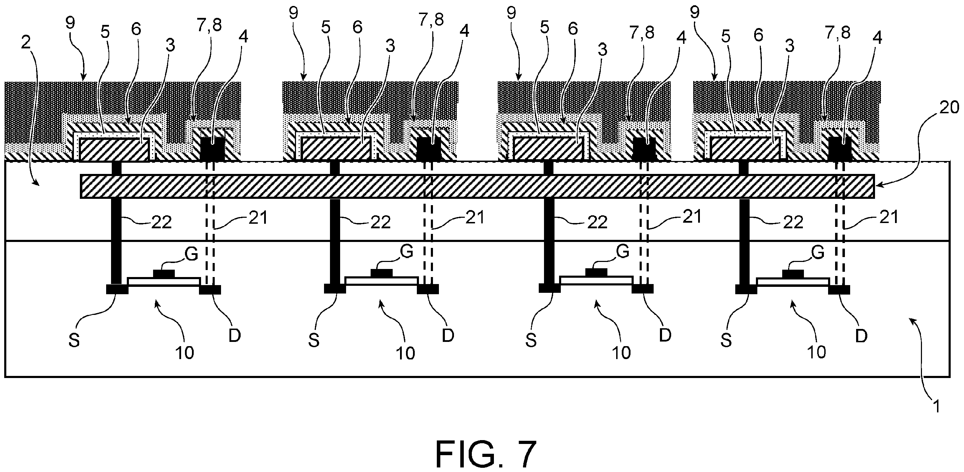

L'étape f) est illustrée à la figure 7.

L'étape f) consiste à graver localement la couche d'encapsulation 8, la couche de recouvrement optique 7 et la couche cathodique 6 de manière à isoler électriquement les couches anodiques 3 entre elles et former une matrice de pixels. Autrement dit, l'étape f) consiste à graver localement la couche d'encapsulation 8, la couche de recouvrement optique 7 et la couche cathodique 6 jusqu'à atteindre la surface de la structure d'interconnexions 2, de manière à isoler électriquement les couches anodiques 3 entre elles de la couche cathodique 6 et former une matrice de pixels. Chaque pixel comprend une couche anodique 3 et un plot 4 de contact électrique, adjacent à ladite couche anodique 3.

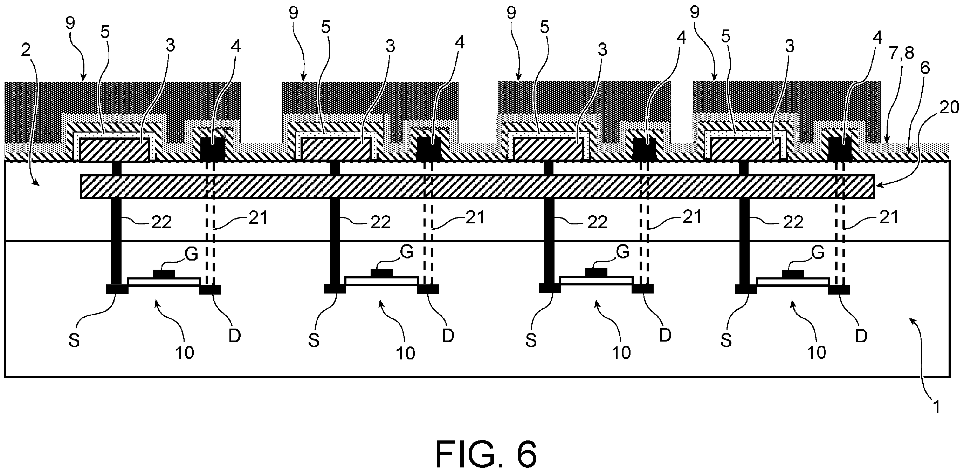

Comme illustré à la figure 6, l'étape f) est avantageusement précédée d'une étape consistant à former un masque de gravure 9 photosensible sur la couche d'encapsulation 8 formée lors de l'étape e), le masque de gravure 9 photosensible étant adapté pour délimiter la matrice de pixels. A titre d'exemple non limitatif, le masque de gravure 9 peut être une résine photosensible tel qu'une résine dénommée JSR (e.g. JSR 420) commercialisée par la société JSR. Le masque de gravure 9 photosensible est réalisé dans un matériau électriquement isolant. Le masque de gravure 9 photosensible est avantageusement conservé à l'issue de l'étape f). A titre d'exemple non limitatif, le masque de gravure 9 photosensible peut présenter une épaisseur de l'ordre de 1,5 µm.

L'étape f) est avantageusement exécutée de sorte que l'ensemble de plots 4 de contact électrique n'est pas exposé à l'issue de la gravure. Plus précisément, le masque de gravure 9 photosensible (illustré à la figure 6) est conçu de sorte que l'ensemble de plots 4 de contact électrique n'est pas exposé à l'issue de la gravure.

L'étape f) est avantageusement exécutée par une gravure par faisceau d'ions IBE (« *Ion Beam Etching* » en langue anglaise). Les paramètres de la gravure IBE, en particulier l'énergie des ions, la directivité des ions et la densité du faisceau d'ions, seront ajustés par l'homme du métier en fonction de l'épaisseur et de la nature des matériaux de la couche cathodique 6, de la couche de recouvrement optique 7 et de la couche d'encapsulation 8.

A titre d'exemple non limitatif, lorsque la couche cathodique 6 est réalisée en argent Ag, la couche de recouvrement optique 7 est réalisée en monoxyde de silicium SiO, la couche d'encapsulation 8 est réalisée en alumine Al₂O₃, l'épaisseur totale de ces couches 6, 7, 8 ne dépassant pas 75 nm, il est possible d'exécuter une gravure IBE avec une directivité des ions de -5° et un courant du faisceau d'ions de 200 mA.

### Etape g)

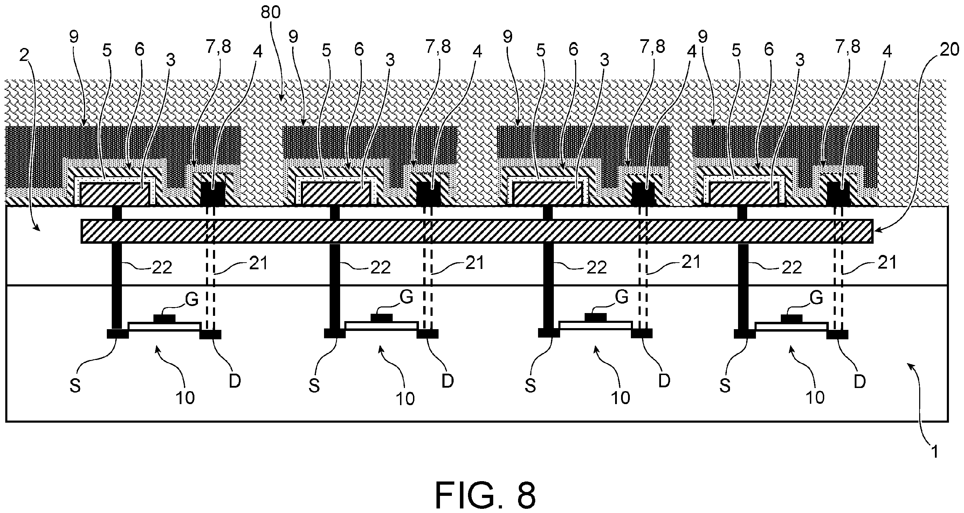

L'étape g) est illustrée à la figure 8.

L'étape f) est avantageusement suivie d'une étape g) consistant à remplir les zones gravées lors de l'étape f) d'un matériau d'encapsulation 80, de préférence l'alumine Al₂O₃. L'étape g) est avantageusement exécutée de manière à former une barrière de type SHB (« *Super High Barrier* » en langue anglaise). Le matériau d'encapsulation 80 est électriquement isolant.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'un dispositif électroluminescent organique, comportant les étapes :
a) utiliser un empilement comportant successivement :
- un substrat (1), intégrant des transistors (10) de type n en couches minces comprenant chacun un drain (D), une source (S) et une grille (G) ;
- une structure d'interconnexions (2), électriquement connectée aux transistors (10) de type n, et comprenant :
une anode commune (20), électriquement connectée aux sources (S) des transistors (10) de type n ;
des trous d'interconnexions (21), chacun étant électriquement connecté à un drain (D) d'un transistor (10) de type n ;
b) former un ensemble de couches anodiques (3) et un ensemble de plots (4) de contact électrique sur une surface de la structure d'interconnexions (2), les couches anodiques (3) étant espacées entre elles de manière à former un réseau de lignes et de colonnes, chaque couche anodique (3) étant électriquement connectée à l'anode commune (20) ; chaque plot (4) de contact électrique étant adjacent à une couche anodique (3) et étant électriquement connecté à un trou d'interconnexion (21) ;
c) former un ensemble d'empilements (5) de couches semi-conductrices organiques, chaque empilement (5) de couches semi-conductrices organiques s'étendant sur une couche anodique (3) et autour de ladite couche anodique (3), à distance du plot (4) de contact électrique adjacent à ladite couche anodique (3) ;
d) former une couche cathodique (6) s'étendant sur la surface de la structure d'interconnexions (2), sur l'ensemble d'empilements (5) de couches semi-conductrices organiques et sur l'ensemble de plots (4) de contact électrique ;
e) former successivement une couche de recouvrement optique (7) et une couche d'encapsulation (8) sur la couche cathodique (6) ;
f) graver localement la couche d'encapsulation (8), la couche de recouvrement optique (7) et la couche cathodique (6) jusqu'à atteindre la surface de la structure d'interconnexions (2), de manière à isoler électriquement les couches anodiques (3) entre elles de la couche cathodique (6) et former une matrice de pixels ; chaque pixel comprenant une couche anodique (3) et un plot (4) de contact électrique, adjacent à ladite couche anodique (3).

2. Procédé selon la revendication 1, dans lequel l'étape f) est exécutée par une gravure par faisceau d'ions.

3. Procédé selon la revendication 1 ou 2, dans lequel l'étape f) est précédée d'une étape consistant à former un masque de gravure (9) photosensible sur la couche d'encapsulation (8) formée lors de l'étape e), le masque de gravure (9) photosensible étant adapté pour délimiter la matrice de pixels.

4. Procédé selon l'une des revendications 1 à 3, dans lequel l'étape b) est exécutée de sorte que le réseau de lignes et de colonnes présente un pas inférieur ou égal à 10 µm.

5. Procédé selon l'une des revendications 1 à 4, dans lequel l'étape f) forme des zones gravées ; et l'étape f) est suivie d'une étape g) consistant à remplir les zones gravées d'un matériau d'encapsulation (80), de préférence l'alumine Al₂O₃.

6. Procédé selon l'une des revendications 1 à 5, dans lequel l'étape e) est exécutée de sorte que la couche de recouvrement optique (7) est réalisée en monoxyde de silicium SiO.

7. Procédé selon l'une des revendications 1 à 6, dans lequel l'étape e) est exécutée de sorte que la couche d'encapsulation (8) est réalisée en alumine Al₂O₃.

8. Procédé selon l'une des revendications 1 à 7, dans lequel l'étape d) est exécutée de sorte que la couche cathodique (6) est réalisée en argent Ag.

9. Procédé selon l'une des revendications 1 à 8, dans lequel les étapes d) et e) sont exécutées de sorte que la couche cathodique (6), la couche de recouvrement optique (7) et la couche d'encapsulation (8) présentent une épaisseur totale inférieure ou égale à 75 nm.

10. Procédé selon l'une des revendications 1 à 9, dans lequel :
- l'étape c) est exécutée avec un masque d'ombre ;
- l'étape d) est exécutée sans masque d'ombre.

11. Procédé selon la revendication 10, dans lequel l'étape c) est suivie d'une étape consistant à retirer le masque d'ombre dans une atmosphère inerte.
